# FASCICULE DE BREVET EUROPEEN

(11) **EP 2 597 473 B1**
(45) Date de publication et mention de la délivrance du brevet: **04.03.2020**
(21) Numéro de dépôt: 12306312.5
(22) Date de dépôt: 23.10.2012
(51) Int. Cl.: G01R 22/06

(54) **Procédé et dispositif de détection d'un shunt entre l'entrée et la sortie de puissance d'un compteur de consommation électrique**
Verfahren und Vorrichtung zur Erkennung eines Shunts zwischen dem Leistungseingang und -ausgang eines elektrischen Stromzählers
Method and device for detecting a shunt between the power input and output of an electricity consumption meter

(30) Priorité: 28.11.2011 FR 1103622
(43) Date de publication de la demande: 29.05.2013
(73) Titulaire: Schneider Electric Industries SAS, 92500 Rueil-Malmaison (FR)
(72) Inventeur: Clemence, Michel, 38050 GRENOBLE Cedex 09 (FR); Contini, Erick, 38050 GRENOBLE Cedex 09 (FR); Coutelou, Olivier, 38050 GRENOBLE Cedex 09 (FR); Waterlot, Frédéric, 38050 GRENOBLE Cedex 9 (FR); Lassalle, Christian, 38050 GRENOBLE Cedex 09 (FR)
(74) Mandataire: Tripodi, Paul

(56) Documents cités:
- EP-A1- 0 084 634
- WO-A1-98/09175
- WO-A2-2008/065291
- GB-A- 2 280 962
- GB-A- 2 281 401
- GB-A- 2 347 225
- US-A- 4 532 471

## Description

### Domaine technique de l'invention

L'invention concerne le domaine de la distribution électrique sur un réseau, notamment un réseau public de type basse tension.

Plus précisément, l'invention porte sur un procédé et un dispositif de détection d'un shunt entre l'entrée et la sortie de puissance d'un compteur de consommation électrique placé sur ce réseau. Elle concerne aussi un procédé de localisation, sur un réseau de distribution d'électricité, d'une fraude par dérivation d'un compteur de relevé de consommation placé sur le réseau.

### État de la technique

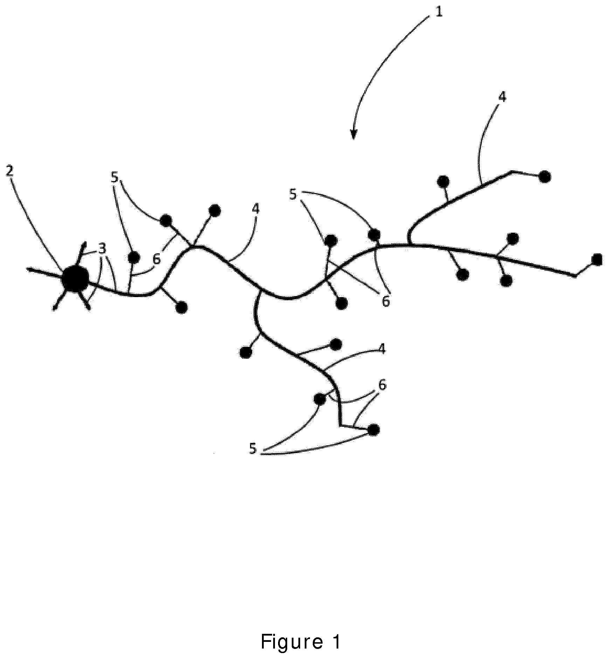

Comme représenté à la figure 1, sur un réseau électrique 1, la distribution terminale d'électricité est réalisée en basse tension (BT) depuis des postes 2 de distribution MT/BT (Moyenne Tension / Basse Tension) vers des consommateurs basse tension 5 (en nombre de l'ordre d'une centaine), notamment des foyers d'habitation. Un poste MT/BT 2 présente plusieurs départs 3 (en nombre de l'ordre de quatre à dix). Chaque départ se déploie en une structure radiale 4 présentant plusieurs branchements monophasés ou triphasés 6. Dans le poste MT/BT 2, se situe un tableau BT répartissant la puissance sur les différents départs 3, chacun éventuellement protégé par des fusibles ou des disjoncteurs.

Les réseaux basse tension sont denses, parfois aériens, parfois souterrains, mélangeant des matériels variables et des câbles d'âges variables. Ils sont exploités par des sociétés d'électricité qui ont pour certaines un historique de l'ordre du siècle durant lequel ce réseau a fait l'objet de modifications, d'extensions, de répartitions. Ces réseaux sont techniquement simples, peu sujets à panne et par le fait bien souvent pas, peu, ou mal documentés.

Deux facteurs viennent se greffer sur ce contexte. D'une part, la dérégulation du secteur de l'électricité impose la séparation des acteurs. Par ailleurs, les réseaux de distribution reviennent aux distributeurs d'électricité qui conservent un statut monopolistique, mais se trouvent sous contraintes des régulateurs nationaux. Ceux-ci imposent à leurs distributeurs des objectifs de qualité de service qui doivent être mesurés, entre autre, en temps et nombre de coupures vues pas chacun des consommateurs raccordés. Ces objectifs sont contraignants et peuvent donner lieu à des pénalités s'ils ne sont pas respectés. Les distributeurs ont par conséquent besoin dorénavant d'une très grande précision sur les données de coupures et d'informations précises pour mieux localiser les éventuels défauts et défaillances.

D'autre part, toujours dans le cadre de la dérégulation, un certain nombre de pays a décidé de déployer des compteurs communicants qui évitent le déplacement de personnels pour assurer les relevés. Selon les contextes réglementaires et selon les distributeurs, différentes architectures ont été retenues pour assurer des opérations de relevés des compteurs à distance. Dans certaines de ces architectures, certains distributeurs ont décidé de mettre en place un concentrateur de données dans chaque poste de distribution MT/BT. Celui-ci assure la collecte des données de chacun des compteurs qui lui sont raccordés. Les données de comptage sont reçues par le biais de courants porteurs en ligne ou par des moyens radioélectriques à fréquence régulière (de l'ordre de la demi-heure à la journée). Le concentrateur de données renvoie ensuite l'ensemble de ces mesures à un niveau supérieur par un autre moyen de communication. Des données de comptage en quasi temps réel de chacun des compteurs sont donc disponibles dans chaque poste MT/BT.

La détection de vol d'énergie au sein du réseau basse tension par les abonnés reste une problématique irrésolue. Or le vol d'énergie a un impact néfaste sur la rentabilité des régies. Ces pertes non techniques sont comptabilisées dans les pertes globales et peuvent représenter 5 à 10% dans les pays Européens et de 30 à 50% en Inde par exemple.

Le vol d'énergie par un abonné consiste en la mise en place d'un shunt entre l'entrée et la sortie de puissance de son compteur de consommation. En soi, la présence d'un tel shunt est souvent indétectable et jamais localisable à distance.

Une solution connue pour détecter un vol d'énergie consiste, au niveau du poste de distribution MT/BT, à calculer la différence entre l'énergie totale fournie au réseau et l'énergie totale consommée d'après les relevés provenant des compteurs communicants. Le résultat permet de détecter une fraude par mise en place de shunt, mais ne permet pas de localiser la fraude sur le réseau. D'autre part, cette solution reste complexe et imprécise en raison du besoin d'estimer les pertes en ligne.

### Objet de l'invention

Le but de l'invention est de fournir un procédé de détection d'un shunt entre l'entrée et la sortie de puissance d'un compteur de consommation électrique qui permette de remédier aux problèmes évoqués précédemment et améliorant les solutions de l'art antérieur.

En particulier, un premier objet de l'invention est de fournir un procédé de détection simple, économique et efficace.

Un deuxième objet de l'invention est de fournir un procédé de détection d'une fraude sur le réseau. Suite à la localisation du contrevenant, il devient avantageusement possible de communiquer les coordonnées aux régies ou aux vendeurs d'énergie.

Selon l'invention, il est proposé un procédé de détection d'un shunt entre l'entrée et la sortie de puissance d'un compteur de consommation électrique selon la revendication 1.

De préférence, Le procédé de détection comprend aussi une étape de détermination des intensités des courants circulant dans des conducteurs de puissance entre les entrée et sortie de puissance du compteur, ladite étape de détermination détermine des valeurs individuelles de courant et/ou une somme vectorielle des courants et/ou une valeur différentielle. De préférence, Le procédé de détection comprend aussi une étape de déduction, à partir de l'étape de détermination, de la présence d'un shunt entre l'entrée et la sortie de puissance du compteur.

De préférence, Le procédé de détection comprend aussi une étape de vérification que les intensités ne dépassent pas une valeur limite au-delà de laquelle l'application des étapes de test sont reportées.

Avantageusement, la modification du premier signal au niveau de l'élément de transformation comprend une atténuation du premier signal par usage d'un filtre de type passe bas.

Avantageusement, l'étape d'analyse comprend l'examen de la présence ou l'absence de détection dans le deuxième signal de premier signal non modifié, la présence de shunt à l'étape de déduction étant déduite en cas d'une présence de détection.

Avantageusement, l'étape d'analyse comprend l'examen du niveau de puissance de premier signal dans le deuxième signal, la présence de shunt à l'étape de déduction étant déduite dans le cas où l'écart entre le niveau de puissance du premier signal dans le deuxième signal et le niveau de puissance du premier signal entre l'entrée de puissance du compteur et l'élément de transformation est inférieur à un seuil donné.

Avantageusement, l'étape de génération est réalisée par un poste de transformation moyenne tension/basse tension en amont du compteur. Avantageusement, l'étape de génération est réalisée par un émetteur intégré dans le compteur.

Avantageusement, les étapes sont réalisées automatiquement de manière périodique.

Un Procédé de localisation, sur un réseau de distribution d'électricité, d'une fraude par dérivation d'un compteur de relevé de consommation placé sur le réseau selon l'invention, comprend une étape d'identification d'un compteur pour lequel la présence d'un shunt a été détectée entre l'entrée et la sortie de puissance en mettant en œuvre un procédé de détection tel que défini ci-dessus.

De préférence, l'étape d'identification comprend l'émission d'un message par un émetteur intégré au compteur.

De préférence, l'émetteur du message est un module comprenant un émetteur de génération du premier signal et/ou un récepteur de démodulation du premier signal.

De préférence, l'émetteur du message fonctionne à des fréquences différentes d'un module intégré au compteur et comprenant un émetteur de génération du premier signal et/ou un récepteur de démodulation du premier signal.

Un dispositif de détection d'un shunt entre une entrée et une sortie de puissance d'un compteur de consommation électrique selon l'invention est défini à la revendication 12.

Dans un mode de réalisation particulier, le dispositif comprend un élément de détermination des intensités des courants circulant dans les conducteurs de puissance entre les entrée et sortie de puissance du compteur, ladite étape de détermination détermine des valeurs individuelles de courant et/ou une somme vectorielle des courants et/ou une valeur différentielle.

Un compteur de consommation électrique selon l'invention comprend tout dispositif de détection tel que défini ci-dessus.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 montre un schéma d'architecture générale d'un réseau de distribution d'électricité basse tension,
- les figures 2 et 3 illustrent des premier et deuxième modes de réalisation d'un compteur de consommation électrique selon l'invention,
- les figures 4 et 5 montrent deux modes de réalisation de filtre passe bas pour constituer l'élément de transformation,
- la figure 6 représente les principes électriques d'un émetteur et récepteur CPL, puis en figure 7 en cas de connexion sur une ligne de courant d'impédance RI.

### Description de modes préférentiels de l'invention

L'invention sera décrite en application à un réseau de distribution d'électricité, par exemple de type basse tension BT depuis un poste de distribution MT/BT (Moyenne Tension / Basse Tension) vers des consommateurs basse tension (en nombre de l'ordre d'une centaine), notamment des foyers d'habitation. Un poste MT/BT présente plusieurs départs (en nombre de l'ordre de quatre à dix) entre lesquels la puissance est répartie au niveau du poste. Chaque départ se compose principalement de trois phases P1, P2 et P3, et d'un neutre N, et se déploie en une structure radiale présentant plusieurs branchements monophasés ou triphasés pour le raccordement de chaque consommateur au départ.

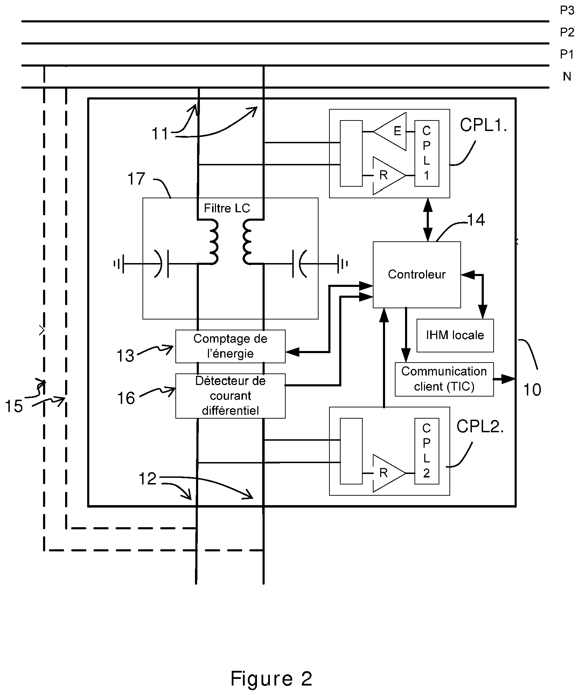

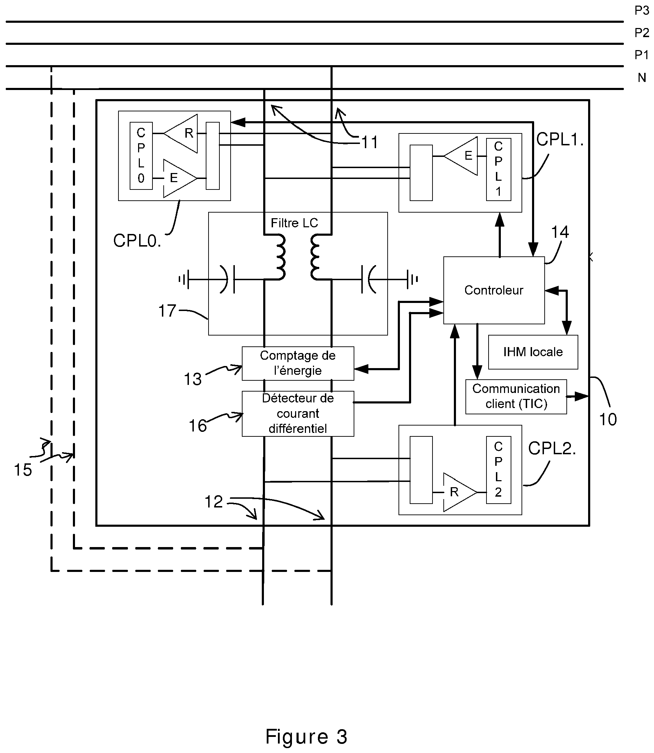

Pour surveiller la consommation des consommateurs basse tension, un branchement monophasé ou triphasé est classiquement équipé d'un compteur de consommation électrique de type communicant ou intelligent. Les figures 2 et 3 illustrent des premier et deuxième modes de réalisation d'un compteur de consommation électrique 10.

Chaque compteur comprend au moins une entrée 11 de puissance raccordée à l'une des phases du réseau (ici par exemple la phase P1 sur les figures 2 et 3) dans le cas d'un branchement monophasé ou aux trois phases dans le cas non représenté d'un branchement triphasé, ainsi qu'au conducteur de neutre N du réseau. Il comprend également au moins une sortie 12 de puissance qui permet d'alimenter le consommateur. Entre l'entrée et la sortie de puissance, le compteur comprend des conducteurs de puissance internes le long desquels est aménagé un élément 13 de comptage de l'énergie.

Chaque compteur est configuré pour pouvoir transmettre régulièrement une information de consommation au poste de distribution MT/BT sur lequel il est raccordé. Une base de données située dans le poste contient les relevés successifs de chacun des compteurs raccordés. Les données de comptage sont reçues à fréquence régulière (de l'ordre de la demi-heure à la journée) avantageusement par le biais de courants porteurs en ligne, mais pourraient l'être par des moyens radioélectriques. Pour l'émission de tels courants porteurs en ligne, le premier mode de réalisation de la figure 2 intègre un module repéré CPL1 comprenant un émetteur E de courant porteur en ligne et un récepteur R de démodulation de courant porteur en ligne. Le deuxième mode de réalisation de la figure 3 intègre quant à lui un module repéré CPLO destiné à l'émission E ou réception R de courants porteurs en ligne à destination ou provenant du poste MT/BT. Les récepteurs des modules CPL1 et CPLO respectivement sur les figures 2 et 3 peuvent notamment servir à la réception des données en provenance du poste MT/BT (tarifs horaires, changements de tarifs, etc...).

Quel que soit le mode de réalisation, le module CPL1 (figure 2) ou le module CPLO (figure 3) sont connectés à un contrôleur 14 lui-même connecté à l'élément de comptage de l'énergie, à une interface locale homme-machine (IHM) et à un élément de communication client (TIC).

Les deux traits en pointillés sur les figures 2 et 3 représentent la mise en place éventuelle d'un shunt 15 ou dérivation entre l'entrée et la sortie de puissance du compteur. Un tel shunt se compose d'un conducteur relié à la phase P1 en amont de l'entrée de puissance et alimentant la phase de la sortie de puissance et/ou d'un conducteur relié au neutre N en amont de l'entrée de puissance et alimentant le neutre de la sortie de puissance.

Un compteur de consommation électrique tel que représenté sur les figures 2 et 3 comprend tout ou partie d'un dispositif de détection qui permet la détection d'un shunt entre la entrée et la sortie de puissance du compteur. Ce dispositif de détection comprend des moyens logiciels et/ou matériels qui mettent en œuvre un procédé de détection et/ou un procédé de localisation décrits ci-dessous.

Notamment, les moyens logiciels et/ou matériels comprennent :
- un élément de génération d'un premier signal,
- un élément de transformation modifiant le premier signal au niveau du compteur entre l'entrée et la sortie de puissance du compteur,
- un élément d'analyse d'un deuxième signal entre l'élément de transformation et la sortie de puissance du compteur,
- et un élément de déduction de la présence ou de l'absence d'un shunt entre l'entrée et la sortie de puissance du compteur.

L'élément de génération du premier signal, ayant une fonction de test, peut être intégré dans le compteur de sorte que le dispositif de détection soit totalement inclus dans le compteur. Il peut être également déporté et à distance par rapport au compteur, par exemple intégré dans le poste MT/BT, et le dispositif de détection n'est alors que partiellement intégré dans le compteur.

Le compteur peut également comprendre un élément 16 de détermination des intensités des courants circulant dans les conducteurs de puissance entre les entrée 11 et sortie 12 de puissance du compteur.L'étape de détermination détermine des valeurs individuelles de courant et/ou une somme vectorielle des courants et/ou une valeur différentielle.

Dans la suite de la description, l'invention sera décrite dans une application particulière en aucun cas limitative dans laquelle le premier signal est constitué par un courant porteur en ligne appelé par la suite « CPL ». Ce signal CPL est notamment destiné à être superposé au signal électrique alternatif principal de puissance, par exemple la tension 230V de 50 Hz, en utilisant un premier signal CPL de plus haute fréquence et de faible énergie. Ce premier signal CPL se propage sur le réseau et peut être reçu et décodé par tout récepteur CPL placé à distance de l'émetteur CPL sur le même réseau électrique. Toutefois le premier signal peut être de toute nature dès lors qu'il permet de parvenir aux résultats de fonctionnement exposés ci-dessous, par exemple sous la forme d'impulsions ou autres. D'autre part, la nature des éléments de génération, de transformation, d'analyse et de déduction est fonction de la nature du premier signal.

L'émetteur de génération du premier signal CPL peut être intégré dans le poste MT/BT. Il peut alternativement être intégré dans le compteur lui-même, à l'aide de l'émetteur du module CPL1 dans le cadre du premier mode de réalisation selon la figure 2 ou grâce à un module CPL1 (comprenant un émetteur de génération du premier signal CPL) dans le cadre du deuxième mode de réalisation selon la figure 3 où l'émetteur du module CPLO qui est destiné aux communications avec le poste MT/BT fonctionne à des fréquences différentes du module CPL1 intégré au compteur pour la génération du signal CPL, notamment très inférieures. De plus, le module CPL1 de la figure 3 peut aussi comprendre un récepteur de démodulation du premier signal CPL destiné à capter ce dernier dans le cas où il serait généré dans le poste MT/BT. L'intérêt du deuxième mode de réalisation de la figure 3 par rapport au premier mode de réalisation de la figure 2 sera présenté plus loin, au cours de la description de cinq exemples de mise en œuvre de l'invention.

Dans le cas d'un premier signal CPL, la modification de celui-ci au niveau de l'élément de transformation peut comprendre une atténuation du premier signal CPL, notamment par usage d'un filtre 17, par exemple de type passe bas. Par exemple, le filtre passe bas est configuré pour atténuer un premier signal CPL dont la fréquence est comprise dans une plage entre 35KHz et 55KHz environ, notamment de l'ordre de 45KHz, ou comprise dans une plage entre 2MHz et 30MHz environ, notamment de l'ordre de 10MHz, et pour supporter un ampérage du signal de puissance compris entre 35A et 55A environ. Le filtre passe bas contient un circuit électrique de type LC avec au moins une bobine et au moins un condensateur, configurés pour réaliser une atténuation du signal de test de l'ordre de 30dB.

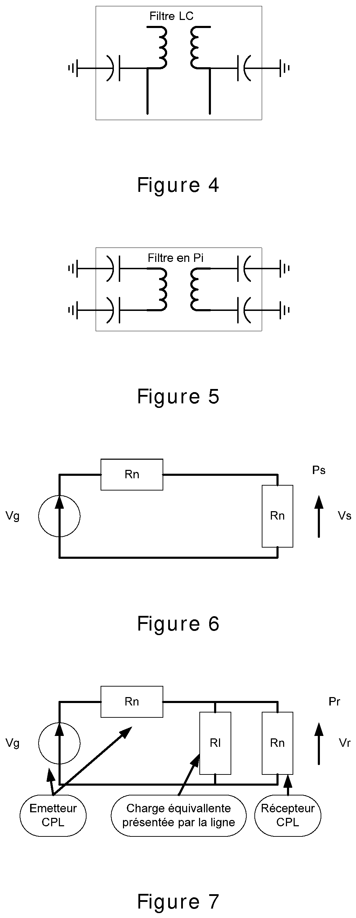

Les figures 4 et 5 illustrent deux modes de réalisation de filtre passe bas pour constituer l'élément de transformation. Ce filtre doit pouvoir laisser passer toute la puissance électrique nécessaire à la fréquence du signal de puissance. Les bobines série de ce filtre doivent donc pouvoir tenir l'ampérage correspondant (45A par exemple). Ce filtre passif ne doit pas être trop onéreux ni trop volumineux, ni abaisser l'impédance de ligne pour la fréquence utile utilisée par la communication CPL. C'est pourquoi un filtre LC tel que représenté sur la figure 4 est préféré, sans exclure la possibilité d'un filtre en Π (PI) tel que représenté sur la figure 5. Des valeurs de Condensateurs de 1µF et de bobines de 200µH permettent d'obtenir l'atténuation recherchée tout en tenant l'ampérage. Les condensateurs de 1µF sont avantageusement de classe X2.

Les bobines doivent accepter un courant permanent de 45A, même si elles saturent à partir d'un certain ampérage (à partir de 10A par exemple). Les bobines peuvent être réalisées en utilisant une ferrite de forme torique,..

Sur ce noyau de ferrite, un bobinage de 69 spires peut être réalisé pour obtenir une bobine de 200µH, et un champ B de 0,3 T pour un courant de 9,3 A (valeur limite avant saturation). Le choix judicieux de cette ferrite permet de repousser assez loin le phénomène de saturation (10A), tout en ayant un nombre de spires pas trop élevé (69 spires). D'autre part, pour que le conducteur accepte l'intensité maximale de courant de 45A de courant maximum (avec saturation), on peut bobiner en parallèle deux fils de cuivre de section de 2,5 mm² pour réaliser les 69 spires.

Sur les figures 2 et 3, le premier signal CPL tel que détecté par CPL1 et présent au moins entre l'entrée de puissance du compteur et l'entrée du filtre passe bas LC intégré au compteur (indépendamment du fait qu'il soit généré dans le poste MT/BT ou dans le module CPL1) est appliqué en entrée du filtre passe bas. Ce dernier étant configuré pour réaliser une atténuation du premier signal CPL à sa fréquence, il en résulte que le deuxième signal situé entre la sortie du filtre passe bas et la sortie de puissance du compteur incorpore le premier signal CPL tel que modifié par le filtre passe bas. En sortie du filtre, on retrouve également le signal de puissance qui n'est pas affecté par le filtre.

Dans le cas où un shunt est placé entre l'entrée et la sortie de puissance du compteur, le premier signal CPL tel que détecté par CPL1, en plus d'être appliqué à l'entrée du filtre passe bas, est dérivé par l'intermédiaire du shunt jusqu'à la sortie de puissance du compteur. Ainsi, le deuxième signal situé entre la sortie du filtre passe bas et la sortie de puissance du compteur incorpore automatiquement, outre le premier signal CPL tel que modifié par le filtre passe bas, le premier signal CPL non modifié par le filtre passe bas. Ainsi, le deuxième signal comprend la superposition du premier signal modifié et le premier signal non modifié. Le deuxième signal comprend le premier signal modifié et le premier signal non modifié

Au contraire, dans le cas où aucun shunt n'est placé entre l'entrée et la sortie de puissance du compteur, le deuxième signal comprend le premier signal modifié, mais pas le premier signal non modifié.

L'ensemble des éléments décrits ci-dessus permet la mise en œuvre d'un procédé permettant de détecter un shunt entre l'entrée et la sortie de puissance du compteur, comprenant les étapes de test suivantes :
- génération d'un premier signal, par exemple de type CPL,
- modification (par exemple sous la forme d'une atténuation) du premier signal par un élément de transformation (par exemple le filtre passe bas LC) au niveau du compteur entre l'entrée et la sortie de puissance du compteur,
- analyse du deuxième signal entre l'élément de transformation et la sortie de puissance du compteur,
- déduction de l'étape précédente de la présence ou de l'absence d'un shunt entre l'entrée et la sortie de puissance du compteur.

L'analyse du deuxième signal consistera notamment à évaluer la présence ou l'absence de premier signal tel que non modifié (ou alternativement évaluer son niveau de puissance) dans le deuxième signal. Autrement dit, l'étape d'analyse peut comprendre l'examen de la présence ou l'absence de détection, dans le deuxième signal, d'un premier signal tel que non modifié. Alternativement, l'étape d'analyse peut comprendre l'examen du niveau de puissance du premier signal (formé par l'addition de la composante modifiée et de la composante non modifiée) dans le deuxième signal, la présence de shunt à l'étape de déduction étant déduite dans le cas où l'écart entre ce niveau et le niveau de puissance du premier signal entre l'entrée de puissance du compteur et l'élément de transformation, est inférieur à un seuil donné.

Pour pouvoir réaliser une telle analyse du deuxième signal dans le cas où le premier signal est de type CPL, les conducteurs entre la sortie du filtre passe bas et la sortie de puissance du compteur peuvent être équipés d'un module noté CPL2 sur les figures 2 et 3 et connecté au contrôleur 14, et comportant à cet effet au moins un récepteur de démodulation du premier signal CPL. Le module CPL2 fonctionne aux mêmes fréquences que le module CPL1, et fonctionne à des fréquences différentes du module CPLO de la figure 3.

Le cas d'une absence de détection de premier signal non modifié dans le deuxième signal correspond au cas où le premier signal, par son atténuation grâce au filtre, est en dessous du seuil de sensibilité de CPL2.

Dans le cas où l'analyse du deuxième signal comprend l'examen du niveau de puissance de premier signal dans le deuxième signal, il sera prévu que le récepteur du module CPL2 soit équipé d'une fonction normalisée « RSSI » pour « Received Signal Strength Indication » en terminologie anglo-saxonne. Dans le cas où le premier signal CPL n'est pas généré par le module CPL1, il pourra aussi être prévu que le récepteur du module CPL1 soit équipé d'une fonction « RSSI ». Cette fonction d'un récepteur CPL donne accès au niveau de puissance du signal CPL qu'il reçoit et démodule, avant modification par le filtre.

En complément, il peut être prévu de déterminer les intensités des courants circulant dans les conducteurs de puissance entre les entrée et sortie de puissance du compteur, et/ou leur somme. Cette étape peut servir ensuite à déduire la présence éventuelle d'un shunt entre l'entrée et la sortie de puissance du compteur. En effet, par cette détermination, il peut éventuellement être constaté un déséquilibre entre une ou plusieurs des phases et le neutre, notamment en cas de shunt à l'aide d'un seul fil conducteur entre les entrée et sortie de puissance du compteur. Le premier signal CPL étant notamment un signal différentiel entre une phase et le neutre, le compteur peut donc comprendre un système de mesure différentiel signalant au contrôleur 14 une différence entre le courant de phase(s) et le courant de neutre. L'étape de détermination des intensités peut aussi servir à l'implémentation d'une étape ultérieure de vérification que les intensités ne dépassent pas une valeur limite au-delà de laquelle l'application des étapes de génération, de modification, d'analyse et de déduction du procédé de détection, sont reportées. En effet, au-delà d'une certaine intensité du courant la performance du filtre peut être insuffisante (comme expliqué plus bas).

Dans ce qui précède, les étapes peuvent avantageusement être réalisées automatiquement de manière périodique, par l'intermédiaire du contrôleur 14 intégré au compteur, par exemple toutes les 20 minutes.

Il peut aussi être prévu l'utilisation du shunt mis en place par le contrevenant comme support de communication permettant de l'identifier, via l'identifiant du compteur dérivé. Suite à la localisation du contrevenant, il devient avantageusement possible de communiquer les coordonnées aux régies ou aux vendeurs d'énergie.

Plus précisément, par une identification d'un compteur de relevé de consommation placé sur un réseau de distribution d'électricité et pour lequel la présence d'un shunt a été détectée entre l'entrée et la sortie de puissance en mettant en œuvre un procédé de détection tel que présenté ci-dessus, il devient possible de localiser, sur le réseau, une fraude par dérivation du compteur.

Cette identification peut notamment comprendre l'émission d'un message, par exemple un message d'alerte, par un émetteur intégré au compteur. Dans le premier mode de réalisation (figure 2), l'émetteur du message est le module CPL1. Dans le deuxième mode de réalisation (figure 3), l'émetteur du message est le module CPLO, qui fonctionne par exemple à des fréquences nettement inférieures aux fréquences de fonctionnement des modules CPL1 et CPL2. L'émission du message se fait à destination d'un récepteur du poste MT/BT du réseau en amont du compteur. Le message pourrait aussi être de nature radioélectrique.

Le dispositif de détection peut être intégré plus globalement dans un système général de transfert d'informations en provenance des compteurs qui permet des fonctions plus générales dites de « smart grid ».

Les technologies de CPL sont aujourd'hui utilisées comme moyen de communication et non pour détecter localement la présence d'un shunt. L'invention prévoit ainsi de détourner largement la technologie CPL de son usage standard.

Afin de décourager les contrevenants, l'information de fraude peut être rendue visible sur le compteur par un voyant indiquant la fraude.

L'invention va être encore mieux comprise à l'aide de cinq exemples de mise en œuvre de l'invention.

Les quatre premiers exemples exploitent le compteur de la figure 2 et le cinquième exemple utilise le compteur de la figure 3. Les premier et troisième exemples diffèrent l'un de l'autre par l'emplacement de l'élément de génération du premier signal CPL (respectivement dans le poste MT/BT ou dans le compteur lui-même). Les deuxième et quatrième exemples sont des variantes respectivement des premier et deuxième exemples pour lesquelles les modules CPL1 et CPL2 ont une fonction RSSI. Le cinquième exemple est une variante du quatrième exemple, avec l'utilisation de modules CPL1 et CPL2 pour le test de détection fonctionnant à des fréquences nettement supérieures à celle du module CPLO utilisée pour les communications avec le poste MT/BT.

Dans le premier exemple, le récepteur du module CPL1 reçoit le premier signal CPL en provenance du poste MT/BT. Si le shunt n'est pas en place, le récepteur du module CPL2 constatera l'absence de premier signal CPL dans le deuxième signal (en raison de son atténuation dans le filtre passe bas en dessous du seuil de détection de CPL2) durant la réception des messages par le récepteur du module CPL1. Il s'agit alors d'une utilisation normale de ce compteur et aucun message d'alerte ne sera remonté vers le poste MT/BT. Au contraire si le shunt est en place, le premier signal CPL tel que non atténué sera reçu aussi par le récepteur du module CPL2 qui va alors indiquer au contrôleur 14 cette anomalie et un message CPL d'alerte pourra être envoyé à destination de poste MT/BT par l'émetteur du module CPL1 pour signifier l'anomalie.

Cependant, ce mode de réalisation nécessite la mise en place d'un filtre passe bas presque parfait. En effet, le poste MT/BT peut se situer soit loin du compteur, soit relativement proche de lui. Le premier signal CPL injecté sur la ligne au niveau du poste MT/BT peut être de l'ordre de grandeur de 10dBm sur une charge de 50ohm par exemple. En cas de proximité entre le poste MT/BT et le compteur, le signal reçu par le module CPL1 peut être atténué de l'ordre de 20dB et être de l'ordre de - 10dBm. Le récepteur CPL2, quant à lui ayant une sensibilité de -70dBm, il faut que le filtre atténue de plus de 60 dB le signal utile.

Dans le deuxième exemple, le récepteur du module CPL1 reçoit le premier signal CPL en provenance du poste MT/BT. Les récepteurs des modules CPL1 et CPL2 possèdent chacun une fonction de type RSSI qui permet de mesurer le niveau du premier signal CPL respectivement en amont et en aval du filtre passe bas. Si le shunt est en place, le premier signal CPL sera reçu par le récepteur du module CPL2 avec à peu près le même niveau de puissance que le récepteur du module CPL1 (niveaux RSSI presque identiques). Les récepteurs des modules CPL1 et CPL2 vont remonter au contrôleur 14 leur niveau de RSSI mesurés. Le contrôleur constatant que ces deux niveaux sont à peu près équivalents va rendre compte de cette anomalie par un message CPL d'alerte qui pourra être envoyé à destination de poste MT/BT par l'émetteur du module CPL1. Si le shunt n'est pas en place au contraire, le niveau de premier signal CPL reçu par le récepteur du module CPL2 sera largement inférieur au niveau reçu par le récepteur CPL1 (30 dB de moins par exemple). Les récepteurs des modules CPL1 et CPL2 vont remonter au contrôleur 14 leur niveau de RSSI mesurés. Le contrôleur constatant que ces deux niveaux sont largement différents, ne va pas déclencher de message d'alerte vers le poste MT/BT.

Ce mode de réalisation nécessite des récepteurs CPL de sensibilité quasiment égale est précise. En effet, en réalité la sensibilité des récepteurs CPL peut être garantie à +/-3dB. Si un shunt est placé sur un compteur en bout de ligne (limite de portée), pour un signal CPL par les récepteurs des modules CPL1 et CPL2 de -72dBm, le signal serait vu par le récepteur du module CPL1 qui aurait une sensibilité de -73dBM et ne serait pas vu du récepteur du module CPL2 qui aurait une sensibilité de - 68 dBm. Ainsi on peut trouver des cas limites et rares pour lesquels l'anomalie risque d'être mal détectée.

C'est pour s'affranchir de ces risques que les trois modes suivants sont envisagés.

Le troisième exemple envisage le cas d'une génération du premier signal CPL par l'émetteur du module CPL1. L'analyse du deuxième signal se pratique par simple évaluation de la présence ou non de premier signal dans le deuxième signal. Les figures 6 et 7 envisagent ce cas particulier, en indiquant respectivement les principes électriques d'un émetteur et récepteur CPL, puis ces principes en cas de connexion sur une ligne de courant d'impédance RI.

Sur la figure 6, un émetteur CPL émet une puissance Ps en étant chargé sur une charge Rn normalisée. Vg et Rn sont respectivement les valeurs de la tension et de la résistance du générateur de Thevenin équivalent au générateur CPL. Cette résistance Rn série du générateur de Thevenin est égale à la résistance normalisée Rn, classiquement de valeur 50 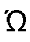 .

Sur la figure 7, soit une ligne de courant qui présente une impédance RI à l'emplacement où l'on connecte à la fois un émetteur CPL et un récepteur CPL d'impédance Rn.

Soit Pr la puissance reçue par le récepteur CPL.
Il peut être démontré que Pr = 20 log [2 / (2 + Rn/RI)] + Ps

Ci-dessous un tableau d'application numérique pour différentes valeurs de charges présentées par la ligne.

| | | | | | | | |
|---|---|---|---|---|---|---|---|
| Ps(dBm) | 10 | 10 | 10 | 10 | 10 | 10 | 10 |
| Rn(ohm) | 50 | 50 | 50 | 50 | 50 | 50 | 50 |
| Rl(ohm) | 1000 | 100 | 10 | 4 | 3 | 2 | 1 |
| Pr(dBm) | 9,79 | 8,06 | -0,88 | -7,21 | -9,40 | -12,61 | -18,30 |

Ce rapide calcul montre que même pour des valeurs d'impédance de ligne supérieures à 3 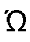 (ce qui constitue une impédance de ligne déjà très basse), le signal reçu par le récepteur CPL est supérieur au signal CPL émis par l'émetteur atténué de 20dB. Ainsi, en choisissant un filtre passe bas de 30dB d'atténuation, si au moment du test l'émetteur du module CPL1 injecte un signal 25 dB au-dessus du seuil de sensibilité du récepteur CPL2, c'est-à-dire -45 dBm, les résultats suivants sont obtenus :
- pour une impédance de ligne de 1000 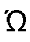 , un signal reçu par le récepteur du module CPL2 de -45dBm en cas de shunt (la fraude sera donc détectée) et de -75 dBm (donc en dessous du seuil de sensibilité) s'il n'y a pas de shunt.
- pour une impédance de ligne de 3 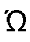 , un signal reçu par le récepteur du module CPL2 de -65dBm en cas de shunt (la fraude sera donc détectée) et de -95 dBm (donc en dessous du seuil de sensibilité) s'il n'y a pas de shunt.

Ainsi pour des impédances de lignes réalistes (c'est-à-dire au moins supérieures à 3 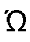 ), avec un filtre passe bas qui atténue de 30dB dans la bande utile, le système permet de détecter la fraude, sans avoir recours à la fonction « RSSI ».

Le quatrième exemple diffère du troisième par l'hypothèse supplémentaire que la fonction « RSSI » est accessible sur le module CPL2, rendant la détection encore plus robuste.

L'émetteur du module CPL1 émet un premier signal CPL périodique (par exemple toutes les 20min) d'un niveau de puissance connu à une fréquence porteuse connue. Le module CPL2 utilise sa fonction de mesure « RSSI » pour mesurer le niveau de puissance du premier signal dans le premier signal. Le récepteur du module CPL2 reçoit seulement le premier signal après atténuation par le filtre lorsqu"il n'y a pas de shunt. Au contraire lorsqu'il y a mise en place d'un shunt, le premier signal dans le deuxième signal se compose du premier signal tel que non atténué par le filtre en plus du premier signal tel qu'atténué. Suite à la détection d'un niveau de puissance du premier signal dans le deuxième signal anormalement élevé, le compteur va émettre vers le poste MT/BT un message d'alerte en indiquant l'identifiant du compteur électrique qui a été shunté (en utilisant la communication de type Smart Grid entre le module CPL1 et le poste MT/BT).

Avant d'effectuer le test envisagé dans le procédé de détection, le contrôleur 10 du compteur s'assure que l'intensité des conducteurs de puissance qui transitent à travers le compteur est inférieure à une certaine valeur (10A par exemple) afin d'assurer que les bobines du filtre passe bas ne sont pas saturées et que le filtre atténue bien de la valeur connue (30dB par exemple). Si le courant qui traverse le compteur est trop important, le test est reporté.

Lorsque la condition précédente est remplie, l'émetteur du module CPL1 émet un premier signal CPL d'un niveau connu (100dBµV par exemple) à une fréquence connue (45kHz par exemple). Le module CPL2 dans les conditions normales recevra uniquement un premier signal atténué de la valeur du filtre (30dB) et donc le signal attendu sera d'environ 70dBµV par exemple (valeur mesurée grâce à la fonction RSSI). Lorsque le compteur est shunté, le premier signal reçu et mesuré par le module CPL2 (valeur donnée par le RSSI) sera pratiquement de 100dBµV.

Le cinquième exemple utilise le compteur intelligent de la figure 3. Pour diminuer la taille du filtre passe bas, il est intéressant d'augmenter la fréquence du premier signal CPL de 45KHz à 10MHz par exemple, en prenant soin de prévoir un émetteur du module CPL1 et un récepteur du module CPL2 adaptés à cette fréquence de 10MHz. Ainsi, la fréquence de coupure du filtre passe bas sera beaucoup plus haute. Une modulation de type ASK ou FSK sur une porteuse dans la bande de 2MHz à 30MHz est largement suffisante. Cette solution est plus économique et moins encombrante.

Le module CPLO sert aux communications avec le poste MT/BT et fonctionne sur des fréquences de la bande CENELEC-A. Le module CPL1 comprend un émetteur CPL simple qui fonctionne sur les bandes de fréquence hautes (par exemple 10MHz). Le module CPL2 comprend un récepteur CPL simple qui fonctionne sur les bandes de fréquence hautes (par exemple 10MHz) pour démoduler le premier signal CPL en provenance du module CPL1 (via le filtre passe bas et éventuellement via le shunt). Une fonction RSSI est disponible sur le module CPL2, rendant la détection robuste.

L'émetteur du module CPL1 émet un premier signal CPL de test périodique (par exemple toutes les 20mn) d'un niveau de puissance connu à une fréquence porteuse connue. Le récepteur du module CPL2 utilise sa fonction de mesure RSSI pour mesurer le niveau de puissance du premier signal dans le deuxième signal. Il reçoit uniquement le premier signal CPL tel qu'atténué par le filtre lorsqu'il n'y a pas présence de shunt. Au contraire en cas de présence de shunt, le premier signal dans le deuxième signal se compose du premier signal tel que non atténué par le filtre en plus du premier signal tel qu'atténué. Suite à la détection d'un niveau de puissance du premier signal dans le deuxième signal anormalement élevé, le compteur va émettre vers le poste MT/BT un message d'alerte en indiquant l'identifiant du compteur électrique qui a été shunté (en utilisant la communication de type Smart Grid entre le module CPL1 et le poste MT/BT).

Avant d'effectuer le test envisagé dans le procédé de détection, le contrôleur 10 du compteur s'assure que l'intensité des conducteurs de puissance qui transitent à travers le compteur est inférieure à une certaine valeur (10A par exemple à la fréquence utile de 10MHz) afin d'assurer que les bobines du filtre passe bas ne sont pas saturées et que le filtre atténue bien de la valeur connue (30dB par exemple). Si le courant qui traverse le compteur est trop important, le test est reporté.

Lorsque la condition précédente est remplie, l'émetteur du module CPL1 émet un premier signal CPL d'un niveau connu (100dBµV par exemple) à sa fréquence de fonctionnement (10MHz par exemple). Le module CPL2 dans les conditions normales recevra uniquement un premier signal atténué de la valeur du filtre (30dB) et donc le signal attendu sera d'environ 70dBµV par exemple (valeur mesurée grâce à la fonction RSSI). Lorsque le compteur est shunté, le premier signal reçu et mesuré par le module CPL2 (valeur donnée par le RSSI) sera pratiquement de 100dBµV.

## Revendications

1. Procédé de détection d'un shunt (15) entre l'entrée (11) et la sortie (12) de puissance d'un compteur (10) de consommation électrique, comprenant les étapes de test suivantes :
- génération d'un premier signal sous la forme d'un courant porteur en ligne,
- modification du premier signal par un élément de transformation au niveau du compteur entre l'entrée et la sortie de puissance du compteur, ledit élément étant un filtre (17) atténuant le premier signal,
- analyse d'un deuxième signal entre l'élément de transformation et la sortie de puissance du compteur par l'utilisation d'un indicateur de niveau de puissance d'un récepteur de courant porteur en ligne,
- déduction de l'étape précédente de la présence ou de l'absence d'un shunt entre l'entrée et la sortie de puissance du compteur.

2. Procédé de détection selon la revendication 1, **caractérisé en ce qu'**il comprend une étape de détermination des intensités des courants circulant dans des conducteurs de puissance entre les entrée (11) et sortie (12) de puissance du compteur, ladite étape de détermination détermine des valeurs individuelles de courant et/ou une somme vectorielle des courants et/ou une valeur différentielle.

3. Procédé de détection selon la revendication 2, **caractérisé en ce qu'**il comprend une étape de déduction, à partir de l'étape de détermination, de la présence d'un shunt (15) entre l'entrée et la sortie de puissance du compteur.

4. Procédé de détection selon l'une des revendications 2 et 3, **caractérisé en ce qu'**il comprend une étape de vérification que les intensités ne dépassent pas une valeur limite au-delà de laquelle l'application des étapes de test de la revendication 1 sont reportées.

5. Procédé de détection selon l'une quelconque des revendications 1 à 4, **caractérisé en ce que** le filtre est de type passe bas.

6. Procédé de détection selon l'une des revendications 1 à 5, **caractérisé en ce que** l'étape d'analyse comprend l'examen de la présence ou l'absence de détection dans le deuxième signal de premier signal non modifié, la présence de shunt (15) à l'étape de déduction étant déduite en cas d'une présence de détection.

7. Procédé de détection selon l'une des revendications 1 à 5, **caractérisé en ce que** l'étape d'analyse comprend l'examen du niveau de puissance de premier signal dans le deuxième signal, la présence de shunt à l'étape de déduction étant déduite dans le cas où l'écart entre le niveau de puissance du premier signal dans le deuxième signal et le niveau de puissance du premier signal entre l'entrée de puissance du compteur et l'élément de transformation est inférieur à un seuil donné.

8. Procédé de localisation, sur un réseau de distribution d'électricité, d'une fraude par dérivation d'un compteur de relevé de consommation placé sur le réseau, **caractérisé en ce qu'**il comprend une étape d'identification d'un compteur pour lequel la présence d'un shunt a été détectée entre l'entrée et la sortie de puissance en mettant en œuvre un procédé de détection selon l'une des revendications 1 à 7.

9. Procédé de localisation selon la revendication 8, **caractérisé en ce que** l'étape d'identification comprend l'émission d'un message par un émetteur intégré au compteur.

10. Procédé de localisation selon la revendication 9, **caractérisé en ce que** l'émetteur du message est un module comprenant un émetteur de génération du premier signal et/ou un récepteur de démodulation du premier signal.

11. Procédé de localisation selon la revendication 10, **caractérisé en ce que** l'émetteur du message fonctionne à des fréquences différentes d'un module intégré au compteur et comprenant un émetteur de génération du premier signal et/ou un récepteur de démodulation du premier signal.

12. Dispositif de détection d'un shunt entre une entrée et une sortie de puissance d'un compteur de consommation électrique, **caractérisé en ce qu'**il comprend des moyens (14) logiciels et/ou matériels qui mettent en œuvre un procédé selon l'une des revendications 1 à 11 comprenant :
- un élément de génération d'un premier signal sous la forme d'un courant porteur en ligne
- un élément de transformation modifiant le premier signal au niveau du compteur entre l'entrée et la sortie de puissance du compteur, ledit élément étant un filtre (17) atténuant le premier signal,
- un élément d'analyse d'un deuxième signal entre l'élément de transformation et la sortie de puissance du compteur par l'utilisation d'un indicateur de niveau de puissance d'un récepteur de courant porteur en ligne,
- et un élément de déduction de la présence ou de l'absence d'un shunt entre l'entrée et la sortie de puissance du compteur.

13. Dispositif de détection selon la revendication 12, **caractérisé en ce qu'**il comprend un élément de détermination des intensités des courants circulant dans les conducteurs de puissance entre les entrée et sortie de puissance du compteur, ladite étape de détermination détermine des valeurs individuelles de courant et/ou une somme vectorielle des courants et/ou une valeur différentielle.

14. Compteur de consommation électrique, **caractérisé en ce qu'**il comprend tout le dispositif de détection selon l'une des revendications 12 ou 13.

## Patentansprüche

1. Verfahren zur Erkennung eines Shunts (15) zwischen dem Leistungseingang (11) und -ausgang (12) eines Stromverbrauchszählers (10), umfassend die folgenden Prüfschritte:
- Erzeugen eines ersten Signals in Form eines PLC-Signals,
- Ändern des ersten Signals durch ein Wandlerelement auf Ebene des Zählers zwischen dem Leistungseingang und -ausgang des Zählers, wobei das Element ein Filter (17) ist, der das erste Signal dämpft,
- Analysieren eines zweiten Signals zwischen dem Wandlerelement und dem Leistungsausgang des Zählers durch die Verwendung eines Leistungspegelanzeigers eines PLC-Empfängers,
- Ableiten des Vorliegens oder Nichtvorliegens eines Shunts zwischen dem Leistungseingang und -ausgang des Zählers aus dem vorhergehenden Schritt.

2. Erkennungsverfahren nach Anspruch 1, **dadurch gekennzeichnet, dass** es einen Schritt des Bestimmens der Stärken der in Leistungsleitern zwischen dem Leistungseingang (11) und -ausgang (12) des Zählers fließenden Ströme umfasst, wobei der Bestimmungsschritt Stromeinzelwerte und/oder eine Vektorsumme der Ströme und/oder einen Differenzwert bestimmt.

3. Erkennungsverfahren nach Anspruch 2, **dadurch gekennzeichnet, dass** es ausgehend von dem Bestimmungsschritt einen Schritt des Ableitens des Vorliegens eines Shunts (15) zwischen dem Leistungseingang und -ausgang des Zählers umfasst.

4. Erkennungsverfahren nach einem der Ansprüche 2 und 3, **dadurch gekennzeichnet, dass** es einen Schritt des Überprüfens umfasst, dass die Stärken einen Grenzwert nicht überschreiten, jenseits dessen die Anwendung der Prüfschritte des Anspruchs 1 verschoben wird.

5. Erkennungsverfahren nach einem der Ansprüche 1 bis 4, **dadurch gekennzeichnet, dass** der Filter vom Tiefpasstyp ist.

6. Erkennungsverfahren nach einem der Ansprüche 1 bis 5, **dadurch gekennzeichnet, dass** der Analyseschritt die Untersuchung des Vorliegens oder Nichtvorliegens einer Erkennung eines nicht geänderten ersten Signals im zweiten Signal umfasst, wobei das Vorliegen eines Shunts (15) im Ableitungsschritt im Fall des Vorliegens einer Erkennung hergeleitet wird.

7. Erkennungsverfahren nach einem der Ansprüche 1 bis 5, **dadurch gekennzeichnet, dass** der Analyseschritt die Untersuchung des Leistungspegels des ersten Signals im zweiten Signal umfasst, wobei das Vorliegen des Shunts im Ableitungsschritt abgeleitet wird, wenn die Abweichung zwischen dem Leistungspegel des ersten Signals im zweiten Signal und dem Leistungspegel des ersten Signals zwischen dem Leistungseingang des Zählers und dem Wandlerelement unter einem gegebenen Schwellenwert liegt.

8. Verfahren zur Positionsbestimmung, in einem Stromverteilernetz, eines Betrugs durch Umgehung eines im Netz angeordneten Zählers zum Ablesen des Verbrauchs, **dadurch gekennzeichnet, dass** es einen Schritt des Identifizierens eines Zählers umfasst, bei dem das Vorliegen eines Shunts zwischen dem Leistungseingang und -ausgang unter Ausführung des Erkennungsverfahrens nach einem der Ansprüche 1 bis 7 erkannt wurde.

9. Positionsbestimmungsverfahren nach Anspruch 8, **dadurch gekennzeichnet, dass** der Identifizierungsschritt das Senden einer Nachricht durch einen in den Zähler integrierten Sender umfasst.

10. Positionsbestimmungsverfahren nach Anspruch 9, **dadurch gekennzeichnet, dass** der Sender der Nachricht ein Modul ist, das einen Sender zum Erzeugen des ersten Signals und/oder einen Empfänger zum Demodulieren des ersten Signals umfasst.

11. Positionsbestimmungsverfahren nach Anspruch 10, **dadurch gekennzeichnet, dass** der Sender der Nachricht mit verschiedenen Frequenzen eines Moduls arbeitet, das in den Zähler integriert ist und einen Sender zum Erzeugen des ersten Signals und/oder einen Empfänger zum Demodulieren des ersten Signals umfasst.

12. Vorrichtung zur Erkennung eines Shunts zwischen einem Leistungseingang und -ausgang eines Stromverbrauchszählers, **dadurch gekennzeichnet, dass** sie Software- und/oder Hardwaremittel (14) umfasst, die ein Verfahren nach einem der Ansprüche 1 bis 11 ausführen, umfassend:
- ein Element zum Erzeugen eines ersten Signals in Form eines PLC-Signals,
- ein Wandlerelement, welches das erste Signal auf Ebene des Zählers zwischen dem Leistungseingang und -ausgang des Zählers ändert, wobei das Element ein Filter (17) ist, der das erste Signal dämpft,
- ein Element zum Analysieren eines zweiten Signals zwischen dem Wandlerelement und dem Leistungsausgang des Zählers durch die Verwendung eines Leistungspegelanzeigers eines PLC-Empfängers,
- und ein Element zum Ableiten des Vorliegens oder Nichtvorliegens eines Shunts zwischen dem Leistungseingang und -ausgang des Zählers.

13. Erkennungsvorrichtung nach Anspruch 12, **dadurch gekennzeichnet, dass** sie ein Element zum Bestimmen der Stärken der in den Leistungsleitern zwischen dem Leistungseingang und -ausgang des Zählers fließenden Ströme umfasst, wobei der Bestimmungsschritt Stromeinzelwerte und/oder eine Vektorsumme der Ströme und/oder einen Differenzwert bestimmt.

14. Stromverbrauchszähler, **dadurch gekennzeichnet, dass** er die gesamte Vorrichtung nach einem der Ansprüche 12 oder 13 umfasst.

## Claims

1. Method for detecting a shunt (15) between the power input (11) and the power output (12) of an electricity consumption meter (10), comprising the following test steps:
- generating a first signal in the form of a power line communication,
- modifying the first signal using a transformation element on the meter between the power input and the power output of the meter, said element being a filter (17) attenuating the first signal,
- analysing a second signal between the transformation element and the power output of the meter using a power level indicator of a power line communication receiver,
- deducing, from the previous step, the presence or the absence of a shunt between the power input and the power output of the meter.

2. Detection method according to Claim 1, **characterized in that** it comprises a step of determining the current strengths flowing in power conductors between the power input (11) and power output (12) of the meter, said determination step determining individual current values and/or a vector sum of the currents and/or a differential value.

3. Detection method according to Claim 2, **characterized in that** it comprises a step of deducing, from the determination step, the presence of a shunt (15) between the power input and the power output of the meter.

4. Detection method according to either of Claims 2 and 3, **characterized in that** it comprises a step of checking that the strengths do not exceed a limit value beyond which the application of the test steps of Claim 1 is deferred.

5. Detection method according to any one of Claims 1 to 4, **characterized in that** the filter is a low-pass filter.

6. Detection method according to one of Claims 1 to 5, **characterized in that** the analysis step comprises examining the presence or the absence of detection of the first non-modified signal in the second signal, the presence of a shunt (15) being deduced in the deduction step in the event of presence of detection.

7. Detection method according to one of Claims 1 to 5, **characterized in that** the analysis step comprises examining the power level of the first signal in the second signal, the presence of a shunt being deduced in the deduction step if the difference between the power level of the first signal in the second signal and the power level of the first signal between the power input of the meter and the transformation element is less than a given threshold.

8. Method for locating, in an electricity distribution network, fraud by bypassing a consumption reader meter placed in the network, **characterized in that** it comprises a step of identifying a meter for which the presence of a shunt has been detected between the power input and the power output by implementing a detection method according to one of Claims 1 to 7.

9. Location method according to Claim 8, **characterized in that** the identification step comprises transmitting a message via a transmitter integrated into the meter.

10. Location method according to Claim 9, **characterized in that** the transmitter of the message is a module comprising a transmitter for generating the first signal and/or a receiver for demodulating the first signal.

11. Location method according to Claim 10, **characterized in that** the transmitter of the message operates at different frequencies from a module integrated into the meter and comprising a transmitter for generating the first signal and/or a receiver for demodulating the first signal.

12. Device for detecting a shunt between a power input and a power output of an electricity consumption meter, **characterized in that** it comprises software means (14) and/or hardware means that implement a method according to one of Claims 1 to 11 comprising:
- an element for generating a first signal in the form of a power line communication,
- a transformation element modifying the first signal on the meter between the power input and the power output of the meter, said element being a filter (17) attenuating the first signal,
- an element for analysing a second signal between the transformation element and the power output of the meter using a power level indicator of a power line communication receiver,
- and an element for deducing the presence or the absence of a shunt between the power input and the power output of the meter.

13. Detection device according to Claim 12, **characterized in that** it comprises an element for determining the current strengths flowing in the power conductors between the power input and power output of the meter, said determination step determining individual current values and/or a vector sum of the currents and/or a differential value.

14. Electricity consumption meter, **characterized in that** it comprises the whole detection device according to either of Claims 12 and 13.
